# EUROPEAN PATENT SPECIFICATION

(11) **EP 0 834 930 B1**
(45) Date of publication and mention of the grant of the patent: **17.10.2001**
(21) Application number: 97120243.7
(22) Date of filing: 18.04.1991
(51) Int. Cl.: H01L 35/32, H01L 35/16

(54) **Thermoelectric semiconductor deaerated into a vacuum and thermoelectric panel using p-type and n-type thermoelectric semiconductors**
Vakuumisolierter thermoelektrischer Halbleiter und thermoelektrisches Bauelement, das P- und N-Typ thermoelektrische Halbleiter benutzt
Semiconducteur thermoélectrique isolé sous vide et panneau thermoélectrique utilisant des semiconducteurs thermoélectriques du type N et P

(30) Priority: 20.04.1990 JP 10303090; 29.11.1990 JP 33591190; 29.11.1990 JP 33592590; 29.11.1990 JP 33592690
(43) Date of publication of application: 08.04.1998
(62) Divisional of application: 91106177.8
(73) Proprietor: MATSUSHITA ELECTRIC INDUSTRIAL CO., LTD., Kadoma-shi, Osaka (JP)
(72) Inventor: Yokotani, Youichirou, Suita-shi, Osaka (JP); Kugimiya, Kouichi, Toyonaka-shi, Osaka (JP); Ando, Hamae, Neyagawa-shi, Osaka (JP)
(74) Representative: Eisenführ, Speiser & Partner

(56) References cited:
- EP-A- 0 122 121
- PATENT ABSTRACTS OF JAPAN vol. 013, no. 173 (E-748), 24 April 1989 -& JP 64 002380 A (IDEMITSU PETROCHEM CO LTD), 6 January 1989,
- PATENT ABSTRACTS OF JAPAN vol. 012, no. 184 (E-614), 28 May 1988 -& JP 62 287678 A (MATSUSHITA REFRIG CO), 14 December 1987,
- PATENT ABSTRACTS OF JAPAN vol. 012, no. 385 (E-668), 14 October 1988 -& JP 63 128681 A (INTERNATL RECTIFIER CORP JAPAN LTD), 1 June 1988,
- PATENT ABSTRACTS OF JAPAN vol. 014, no. 320 (E-0950), 10 July 1990 -& JP 02 106079 A (CKD CORP;OTHERS: 01), 18 April 1990,
- PATENT ABSTRACTS OF JAPAN vol. 014, no. 248 (E-0933), 28 May 1990 -& JP 02 071568 A (UBE IND LTD), 12 March 1990,

## Description

### BACKGROUND OF THE INVENTION

### 1. Field of the Invention

The present invention relates to a thermoelectric semiconductor device and an electronic refrigeration panel as defined in the preambles of claims 1 and 8 respectively.

### 2. Description of the Prior Art

Recently, electronic devices such as electronic refrigeration, heating and thermoelectric power generation devices which utilize the Peltier effect and/or the Seeback effect have been highly demanded from various demands such as inhibition of freon due to the global atmospheric problem, local refrigeration for electronic apparatuses, small refrigerator for dehumidification, utilization of waste heat of a small amount and the like.

In a conventional electronic refrigeration panel, p-type and n-type semiconductor elements each made of a Bi-Te system single or poly-crystalline solid material are arranged alternatively in a two-dimensional configuration and electrically connected in series using Cu plates as electrodes.

In a conventional thermoelectric device, poly-crystalline sintered material such as Fe₂Si or the like is used and p-type and n-type semiconductor elements are jointed with each other directly.

It has been known that a heat absorption amount per a consumed power at the refrigerating side of the electronic refrigeration panel is determined by the performance factor of the semiconductive material used and that the performance factor is represented -by Z =S^{2.}σ/k using Seebeck coefficient S, electrical conductivity σ and thermal conductivity k of the semiconductive material. As is apparent form the above equation, the semiconductive material therefor is preferably demanded to have a large Seebeck coefficients, a high electric conductivity σ and a low thermal conductivity K. Further, in driving a method of the refrigerator of this type, it is driven intermittently after reaching a predetermined refrigeration temperature. In such a case, it is demanded to have a high adiabatic property at the time when no voltage is applied thereto. In the thermoelectric power generation device, each semiconductor element is demanded to have a low thermal conductivity in order to maintain a temperature difference between higher and lower temperature sides.

Further, in a semiconductive material such as Bi-Te system material, there have been proposed various technics such that Sb and/or Se are added thereto to reduce a lattice vibration in a heat conduction and that a polycrystalline solidified body with a controlled grain size is made without making a single crystal grow from a molten state to lower the thermal conductivity thereof.

In an electronic refrigeration device, it is said theoretically that it is possible to obtain a temperature difference of about 60 °C between the higher and lower temperature sides in a Bi-Te system semiconductive material. However, there is the problem that the lowest achievable temperature at the lower temperature side becomes higher due to an increase of the temperature at the higher temperature side if the amount of heat radiation occurring there is small. The thermal resistance between an ordinary radiation plate and an ambient atmosphere is about 0.0002 to 0.0005 W/cm²·deg under spontaneous cooling and about 0.0004 to 0.0002 W/cm²·deg under forcible air cooling. Accordingly, temperature rise at the radiation side (higher temperature side) is a serious problem.

To solve this problem, in a conventional refrigeration panel, a plurality of p-type and n-type semiconductor elements are arranged alternatively in a rectangular configuration, but with a gap therebetween to give a cross section two or three times as large as the sum of their cross sections obtained when they are arranged in contact with each other. Moreover a heat radiation plate having an area about ten times as large as the above sum of their cross sections and fins each having an area about 5 to 7 times as large as the above sum are provided to give a total radiation area about 100 to 200 times as large as the above sum. The heat radiation plate and fins are forcibly air-cooled by a fan or water cooled.

However, there is a strong demand to cool a large refrigeration plane to a low temperature without using a large radiation plane and forcible cooling. If such a demand is realized such devices can be widely used for a refrigeration panel of a large size and a wall of a cold reserving chamber.

Further, in a conventional structure, bedewings are apt to occur at the lower temperature side and disconnections are often caused at junctions between the element and the electrode by corrosions due to bedewings.

EP-A-0 122 121 discloses a thermoelectric device including a plurality of thermoelectric elements, coupling means on opposite sides of the elements interconnecting the elements electrically according to a predetermined pattern, and encapsulant means including an encapsulant material covering the exposed surfaces of the elements. The encapsulant forms void spaces between the elements for effective thermal insulation and confining substantially all of the heat flow from the temperature gradient to and through the elements. The coupling means include electrically conductive plate segments for interconnecting the elements. The segments are joined to the elements on respective opposite sides and are contacted and held in fixed relative relation by the encapsulant. The segments define an outer periphery of the device and the encapsulant material bridge across the segments at the periphery of the device.

### SUMMARY OF THE INVENTION

It is the object of the present invention to provide a thermoelectric semiconductor device that are suitable for use in an electronic refrigeration device and/or a thermoelectric power generation device. An aspect of this object is to provide an electronic refrigeration panel.

This object is solved by a thermoelectric semiconductor device according to claim 1 and by an electronic refrigeration panel according to claim 8. Preferred embodiments of the device and panel are defined in the respective subclaims.

The invention provides a thermoelectric semiconductor device having a structure wherein a predetermined number of p-type and n-type thermoelectric semiconductor elements is arranged in a two-dimensional configuration and is alternatingly electrically connected in series, wherein the device utilizes a heat generation and/or adsorption phenomenon caused by supplying a DC current to said p-type or n-type thermoelectric semiconductor elements or an electromotive force caused by a temperature difference given at each junction between said p-type and n-type thermoelectric semiconductor elements. The p-type and n-type thermoelectric semiconductor elements are arranged such that a space is provided between each pair of them, each space being filled with an adiabatic insulation material and being deaerated to a vacuum by an air-tight sealing.

According to a preferred embodiment, each of said p-type and n-type thermoelectric semiconductor elements is made of a porous material.

According to another preferred embodiment of their thermoelectric semiconductor device, the adiabatic insulation material is an inorganic material which may be an inorganic porous material or an inorganic powder material.

According to a further preferred embodiment, the spaces filled with said inorganic material are deaerated to a vacuum of 1.3 mbar (1 mm Hg) or less.

According to still a further embodiment, the pores in the p-type and n-type thermoelectric semiconductor elements are deaerated to a vacuum of 1.3 mbar (1 mm Hg) or less.

The invention also provides an electronic refrigeration panel comprising a thermoelectric semiconductor device wherein the p-type and n-type semiconductor elements are made of a thermoelectric semiconductive material supported by support particles.

According to a preferred embodiment of the refrigeration panel, the thermoelectric semiconductor material forms a continuous layer made by sintering it.

The support particles may be hollow particles or porous particles.

### BRIEF DESCRIPTION OF THE DRAWINGS

These and other objects and features of the present invention will become clear from the following description taken in conjunction with the preferred embodiments thereof with reference to the accompanying drawings in which:
Fig. 1 is a view of a refrigeration panel
Fig. 2 is a cross-sectional view of a refrigeration panel in which gaps between p-type and n-type semiconductive elements are filled with an adiabatic material,
Fig. 3 is a cross-sectional view of a refrigeration panel in which the inner space of the panel is evacuated to a vacuum,
Fig. 4 is a cross-sectional view of a refrigeration panel according to a preferred embodiment of the present invention,
Fig. 5 is a cross-sectional view showing a variation of the preferred embodiment of the present invention.

### DETAILED DESCRIPTION OF THE PREFERRED EMBODIMENTS

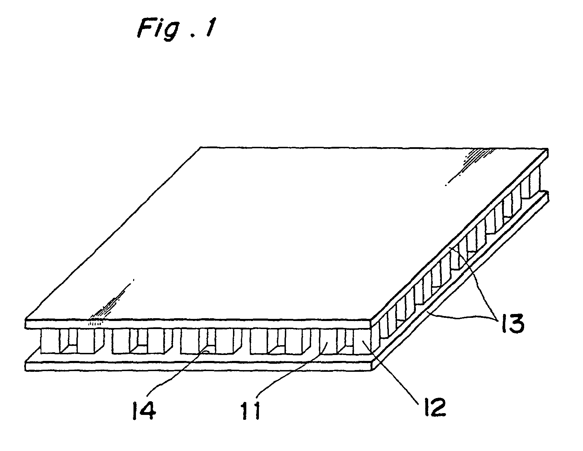

Fig.1 shows a thermoelectric refrigeration panel. The refrigeration panel is comprised of two rectangular alumina plates 13 and 13 and p-type and n-type semiconductor elements 11 and 12 arranged between said two alumina plates 13 and 13 in a matrix form of 15 × 15 regularly and alternatively. These semiconductor elements 11 and 12 are connected in series by elongated Ni plates 14. Each element is a cube of, for example, 1.5 × 1.5 × 1.5 mm³.

As semiconductive materials for manufacturing these elements, Bi-Te system materials are used. More concretely, (Bi, Sb)₂Te₃ and Bi₂(Te, Se)₃ are chosen.

In a manufacturing method therefor, after crushing poly-crystalline solidified bodies of these materials as starting materials, they are milled into a powder by a ball mill using zirconia balls of a diameter of 2mmφ and a solvent of ethanol. After drying the powder, it is- filled in a tube of platinum and sealed therein after deaeration and then subjected to an HIP treatment at 500 °C and under a pressure of 10 to 1000 Kg/cm².

The sample thus formed was taken out from the tube and cut into pieces of 3 mm × 3 mm × 20 mm. The bulk density of the sample was measured at a room temperature and the porosity thereof was determined. The Seebeck coefficient thereof was also determined by measuring the electromotive force and temperatures at both ends of each piece while maintaining a temperature difference of 5 °C between both ends thereof at a room temperature. Further, the electric conductivity thereof was determined by measuring a resistance of the piece by the four terminal method while maintaining it at room temperature. Also, the performance factor Z of the piece was measured according to the Harmer method while hanging both ends of the piece with conductive wires of 0.07 mmφ in a vacuum at room temperature and the thermal conductivity was determined from the electric conductivity and the Seebeck coefficient.

Table 1 indicates the porosity, electric conductivity, Seebeck coefficient, thermal conductivity and performance factor of the p-type semiconductor element 11 and Table 2 indicates those of the n-type semiconductor element 12.

Further, by measuring the thermal conduction between the upper and lower alumina plates 13, the thermal conductivity of the panel per unit area was determined.

Table 3 indicates the porosity of the semiconductor element and the thermal conductivity of the panel.

**Table 1**

| Sample No. | Porosity Vol% | Electric conductivity 10⁻³Ωcm | Thermal conductivity W/cm·deg | Seebeck coefficient µV/deg | Performance factor 10⁻³/deg |
|---|---|---|---|---|---|
| 11 | 0 | 1.37 | 0.014 | 171 | 2.86 |
| 12 | 1.5 | 1.35 | 0.0138 | 171 | 2.86 |
| 13 | 5 | 1.33 | 0.0132 | 172 | 2.98 |
| 14 | 10 | 1.28 | 0.0125 | 170 | 2.96 |
| 15 | 30 | 0.92 | 0.0092 | 168 | 2.82 |
| 16 | 50 | 0.68 | 0.0072 | 165 | 2.57 |

**Table 2**

| Sample No. | Porosity Vol% | Electric conductivity 10⁻³Ωcm | Thermal conductivity W/cm·deg | Seebeck coefficient µV/deg | Performance factor 10⁻³/deg |
|---|---|---|---|---|---|
| 17 | 0 | 1.16 | 0.0151 | -192 | 2.83 |
| 18 | 1.5 | 1.15 | 0.0150 | -191 | 2.80 |
| 19 | 5 | 1.12 | 0.0142 | -192 | 2.91 |
| 20 | 10 | 1.07 | 0.0132 | -188 | 2.87 |
| 21 | 30 | 0.76 | 0.0099 | -179 | 2.46 |
| 22 | 50 | 0.59 | 0.0076 | -175 | 2.38 |

**Table 3**

| Sample No. | Porosity | Thermal conductivity |
|---|---|---|
| *23 | 0 | 0.0372 |
| 24 | 1.5 | 0.0367 |
| 25 | 5 | 0.0354 |
| 26 | 10 | 0.0335 |
| 27 | 30 | 0.0268 |
| 28 | 50 | 0.0207 |

| | | |
|---|---|---|
| * indicates a sample wherein poly-crystalline solidified bodies were used for the semiconductor elements. | | |

As is apparent from Tables 1 to 3, the semiconductor having pores therein has a lower thermal conductivity and that of the refrigeration panel using the same is also low. Further, it is to be noted that the performance factor of the semiconductor having a porosity higher than 5 % does not become so low though the thermal conductivity thereof is much lowered.

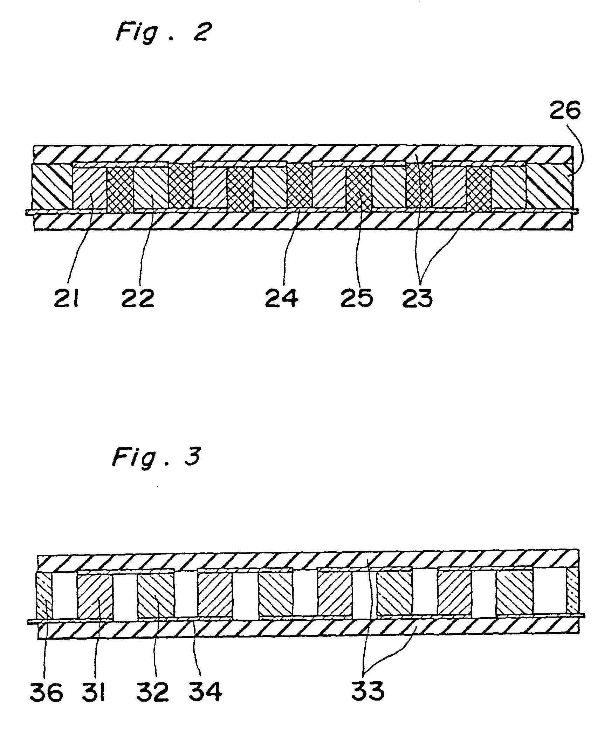

Fig. 2 is a schematic cross-sectional view of another thermoelectrical refrigeration panel. This refrigeration panel has substantially the same structure as that shown in Fig. 1.

In this embodiment, respective gaps between p-type and n-type semiconductor elements 21 and 22 arranged between two alumina plates 23 are filled with an adiabatic material 25 such as glass fibre having a bulk density of 0.04 g/cm² or powder of pearlite having an average diameter of 15 µm. Each side of the panel is sealed with an inorganic adhesive agent 26. Reference numeral 24 indicates an Ni plate connecting adjacent elements.

Semiconductor elements 21 and 22 are made of a semiconductive material having a porosity of 30 %.

Table 4 shows respective thermal conductivities of-the refrigeration panel.

**Table 4**

| Case No. | Composition | Thermal conductivity W/cm²·deg |
|---|---|---|
| *23 | Porosity 0 % gaps: not filled | 0.0372 |
| 29 | Porosity 30 % gaps: not filled | 0.0268 |
| 30 | Porosity 0 % gaps filled with glass fibre | 0.0361 |
| 31 | Porosity 30 % gaps filled with glass fibre | 0.0254 |
| 32 | Porosity 0 % gaps filled with pearlite powder | 0.0357 |
| 33 | Porosity 30 % gaps filled with pearlite powder | 0.0251 |

As is easily understood from Table 4, the thermal conductivity of the refrigeration panel can be lowered in the case that gaps are filled with an inorganic porous material or powder since no thermal conduction due to neumatic convection flow occurs therein.

Also, it is to be noted that the thermal conductivity of the refrigeration panel using porous semiconductor elements is smaller than that using nonporous semiconductor elements.

Fig. 3 shows a schematic cross-sectional view of a further thermoelectric refrigeration panel. The refrigeration panel has a structure substantially the same as that of the refrigeration panel shown in Fig. 2. Namely, p-type and n-type semiconductor elements 31 and 32 are regularly arranged between alumina plates 33 and connected in series by Ni plates 34.

Instead of filling gaps with an adiabatic material, the inner space of the panel is evacuated to a vacuum of about 4.3 × 10⁻³ mbar (0.001 mmHg) by heating the panel so as to melt a sealing glass 36 arranged around the periphery thereof and then cooling the same.

Table 5 shows respective thermal conductivities of the refrigeration panels.

**Table 5**

| Case No. | Composition | Thermal conductivity W/cm²·deg |
|---|---|---|
| *23 | Porosity 0 % gaps filled with air | 0.0372 |
| 34 | Porosity 30 % gaps filled with air | 0.0268 |
| 35 | Porosity 0 % gaps in a vacuum | 0.0351 |
| 36 | Porosity 30 % gaps in a vacuum | 0.0233 |

As is apparent from Table 5, the refrigeration panels wherein the inner space thereof is kept in a vacuum exhibit small thermal conductivities since no heat conduction due to neumatic convection flow occurs therein.

The third embodiment is advantageous in that it is possible to prevent connecting portions between the element and the Ni plate from corrosion and detorioration since no dew condensation occurs in a vacuum.

Fig. 4 shows a cross-sectional view of a thermoelectrical refrigeration panel according to a preferred embodiment of the present invention.

In this preferred embodiment, gaps between p-type and n-type semiconductor elements 41 and 42 arranged between two alumina plates 43 and connected by Ni plates 44 are filled with an inorganic adiabatic material 45 such as glass fibre having a bulk density of 0.04 g/cm³ or pearlite powder having an average grain size of 15 µm and the inside thereof is kept in an evacuated state to 1.3×10⁻² mbar (0.01 mmHg) by a glass sealing 46 according to a method similar to that of the third embodiment.

Fig. 5 shows a variation of Fig. 4.

In this variation, the inner side of the refrigeration panel is deaerated to a vacuum of about 1.3 mbar (1 mmHg) after sealing the periphery thereof with a resin layer of about 1 mm thickness and, thereafter, sealed airtightly.

Table 6 shows the thermal conductivity per unit area with respect to refrigeration panels prepared according to the preferred embodiment together with a comparison example.

**Table 6**

| Case No. | Composition | | | Thermal conductivit y W/cm²·deg |
|---|---|---|---|---|
| | porosity | filling material | sealing state | |
| *23 | 0 % | no (air) | | 0.0372 |
| 37 | 30 % | no (air) | | 0.0268 |
| 38 | 0 % | glass fibre | glass seal 0.01 mmHg | 0.0351 |
| 39 | 30 % | glass fibre | glass seal 0.01 mmHg | 0.0235 |
| 40 | 0 % | pearlite powder | glass seal 0.01 mmHg | 0.0352 |
| 41 | 30 % | pearlite powder | glass seal 0.01 mmHg | 0.0235 |
| 42 | 0 % | pearlite powder | resin seal 1.00 mmHg | 0.0352 |
| 43 | 30 % | pearlite powder | resin seal 1.00 mmHg | 0.0240 |
| 44 | 0 % | no (air) | resin seal 1.00 mmHg | 0.0364 |
| 45 | 30 % | no (air) | resin seal 1.00 mmHg | 0.0260 |
| 0.01 mmHg = 1.3 × 10⁻² mbar | | | | |
| 1 mmHg = 1.3 mbar | | | | |

As is apparent from Table 6, the preferred embodiment can enjoy advantages similar to those obtained in the second and third embodiments.

## Claims

1. A thermoelectric semiconductor device having a structure wherein a predetermined number of p-type and n-type thermoelectric semiconductor elements (11, 12; 21, 22; 31, 32; 41, 42; 51, 52) is arranged in a two-dimensional configuration and is alternatingly electrically connected in series, wherein the device utilizes a heat generation and/or adsorption phenomenon caused by supplying a DC current to said p-type or n-type thermoelectric semiconductor elements (11, 12; 21, 22; 31, 32; 41, 42; 51, 52) or an electromotive force caused by a temperature difference given at each junction between said p-type and n-type thermoelectric semiconductor elements (11, 12; 21, 22; 31, 32; 41, 42; 51, 52),
**characterized in that**
said p-type and n-type thermoelectric semiconductor elements (11, 12; 21, 22; 31, 32; 41, 42; 51, 52) are arranged such that a space is provided between each pair of them, each space being filled with an adiabatic insulation material (25) and being deaerated to a vacuum by an air-tight sealing.

2. The device of claim 1, wherein each of said p-type and n-type thermoelectric semiconductor elements (11, 12; 21, 22; 31, 32; 41, 42; 51, 52) is made of a porous material.

3. The device of claim 1 or 2, wherein said adiabatic insulation material is an inorganic material (45, 55).

4. The device of claim 3, wherein said inorganic material (45, 55) is an inorganic porous material.

5. The device of claim 3, wherein said inorganic material (45, 55) is an inorganic powder material.

6. The device of any one of claim 3 to 5, wherein said spaces filled with said inorganic material are deaerated to a vacuum of 1.3 mbar (1 mm Hg) or less.

7. The device of claims 2 and 3, wherein the pores in said p-type and n-type thermoelectric semiconductor elements are deaerated to a vacuum of 1.3 mbar (1 mm Hg) or less.

8. An electronic refrigeration panel comprising a thermoelectric semiconductor device according to claim 2,
**characterized in that**
said p-type and n-type semiconductor elements (11, 12; 21, 22; 31, 32; 41, 42; 51, 52) are made of a thermoelectric semiconductive material supported by support particles.

9. The refrigeration panel of claim 8, wherein said thermoelectric semiconductor material forms a continuous layer made by sintering the same.

10. The refrigeration panel of claim 8, wherein said support particles are hollow particles.

11. The refrigeration panel of claim 8, wherein said support particles are porous particles.

## Patentansprüche

1. Thermoelektrische Halbleitereinrichtung mit einem Aufbau, bei dem eine vorgewählte Anzahl von thermoelektrischen Halbleiterelementen (11, 12; 21, 22; 31, 32; 41, 42; 51, 52) des p-Typs und n-Typs zweidimensional angeordet und alternierend elektrisch in Serie geschaltet ist, wobei die Halbleitereinrichtung ein Wärmeerzeugungs- und/oder Absorptionsphänomen verwendet, welches erzeugt wird durch Anlegen einer Gleichspannung an die Halbleiterelemente (11, 12; 21, 22; 31, 32; 41, 42; 51, 52) des p-Typs oder n-Typs oder durch eine elektromotorische Kraft, die durch eine Temperaturdifferenz entsteht, die an jeder Verbindung der thermoelektrischen Halbleiterelemente (11, 12; 21, 22; 31, 32; 41, 41; 51, 52) des p-Typs und n-Typs gegeben ist,
**dadurch gekennzeichnet, dass**
die thermoelektrischen Halbleiterelemente (11, 12; 21, 22; 31, 32; 41, 42; 51, 52) des p-Typs und n-Typs so angeordnet sind, dass zwischen jedem Paar von ihnen ein Raum vorgesehen ist, wobei jeder Raum mit einem adiabatischen Isolationsmaterial (25) gefüllt und mit einer luftdichten Versiegelung vakuumevakuiert ist.

2. Einrichtung nach Anspruch 1, bei der jedes der thermoelektrischen Halbleiterelemente (11, 12; 21, 22; 31, 32;41, 42; 51, 52) des p-Typs und n-Typs aus einem porösem Material hergestellt ist.

3. Einrichtung nach Anspruch 1 oder 2, bei der das adiabatische Isolationsmaterial ein anorganisches Material (45, 55) ist.

4. Einrichtung nach Anspruch 3, bei der das anorganische Material (45, 55) ein anorganisches poröses Material ist.

5. Einrichtung nach Anspruch 3, bei der das anorganische Material (45, 55) ein anorganisches pulverförmiges Material ist.

6. Einrichtung nach einem der Ansprüche 3 bis 5, bei der die mit dem anorganischen Material gefüllten Räume auf ein Vakuum von 1,3 mbar (1 mm Hg) oder kleiner evakuiert sind.

7. Einrichtung nach den Ansprüchen 2 und 3, bei der die Poren der thermoelektrischen Halbleiterelemente des p-Typs und n-Typs auf ein Vakuum von 1,3 mbar (1 mm Hg) oder kleiner evakuiert sind.

8. Elektronisches Kühlschrankpaneel, aufweisend eine thermoelektrische Halbleitereinrichtung nach Anspruch 2,
**dadurch gekennzeichnet, dass**
die Halbleiterelemente (11, 12; 21, 22; 31, 32; 41, 42; 51, 52) des p-Typs und n-Typs aus einem thermoelektrischen Halbleitermaterial hergestellt sind, welches von Trägerteilchen getragen ist.

9. Kühlschrankpanell nach Anspruch 8, bei dem das thermoelektrische Halbleitermaterial eine kontinuierliche Schicht bildet, die hergestellt wurde, in dem man diese Sintert.

10. Kühlschrankpaneel nach Anspuch 8, bei dem die Trägerteilchen hohle Teilchen sind.

11. Kühlschrankpaneel nach Anspruch 8, bei dem die Trägerteilchen poröse Teilchen sind.

## Revendications

1. Dispositif thermoélectrique à semiconducteurs présentant une structure dans laquelle un nombre prédéterminé d'éléments de semiconducteurs thermoélectriques de type p et de type n (11, 12 ; 21, 22 ; 31, 32 ; 41, 42 ; 51, 52) sont disposés suivant une configuration bidimensionnelle et sont de façon alternée électriquement reliés en série, dans lequel le dispositif utilise une génération de chaleur et/ou un phénomène d'adsorption provoqué par la fourniture d'un courant continu auxdits éléments de semiconducteurs thermoélectriques de type p ou de type n (11, 12 ; 21, 22 ; 31, 32 ; 41, 42 ; 51, 52) ou une force électromotrice provoquée par une différence de température donnée à chaque jonction entre lesdits éléments de semiconducteurs thermoélectriques de type p et de type n (11, 12 ; 21, 22 ; 31, 32 ; 41, 42 ; 51, 52),
**caractérisé en ce que**
lesdits éléments de semiconducteurs thermoélectriques de type p et de type n (11, 12 ; 21, 22 ; 31, 32 ; 41, 42 ; 51, 52) sont disposés de sorte qu'un espace soit réalisé entre chaque paire de ceux-ci, chaque espace étant rempli par un matériau isolant adiabatique (25) et étant désaéré jusqu'à un vide grâce à une obturation hermétique.

2. Dispositif selon la revendication 1, dans lequel chacun desdits éléments de semiconducteurs thermoélectriques de type p et de type n (11, 12 ; 21, 22 ; 31, 32 ; 41, 42 ; 51, 52) est fait d'un matériau poreux.

3. Dispositif selon la revendication 1 ou 2, dans lequel ledit matériau isolant adiabatique est un matériau inorganique (45, 55).

4. Dispositif selon la revendication 3, dans lequel ledit matériau inorganique (45, 55) est un matériau inorganique poreux.

5. Dispositif selon la revendication 3, dans lequel ledit matériau inorganique (45, 55) est un matériau inorganique en poudre.

6. Dispositif selon l'une quelconque des revendications 3 à 5, dans lequel lesdits espaces remplis avec ledit matériau inorganique sont désaérés jusqu'à un vide de 1,3 mbar (1 mm Hg) ou moins.

7. Dispositif selon la revendication 2 et 3, dans lequel les pores dans lesdits éléments de semiconducteurs thermoélectriques de type p et de type n sont désaérés jusqu'à un vide de 1,3 mbar (1 mm Hg) ou moins.

8. Panneau de réfrigération électronique comprenant un dispositif thermoélectrique à semiconducteurs selon la revendication 2,
**caractérisé en ce que**
lesdits éléments de semiconducteurs de type p et de type n (11, 12 ; 21, 22 ; 31, 32 ; 41, 42 ; 51, 52) sont fait d'un matériau thermoélectrique semiconducteur supporté par des particules de support.

9. Panneau de réfrigération selon la revendication 8, dans lequel ledit matériau thermoélectrique de semiconducteur forme une couche continue faite en frittant celui-ci.

10. Panneau de réfrigération selon la revendication 8, dans lequel lesdites particules de support sont des particules creuses.

11. Panneau de réfrigération selon la revendication 8, dans lequel lesdites particules de support sont des particules poreuses.
